Europäisches Patentamt

European Patent Office

Office européen des brevets

(19)

(11) **EP 0 823 711 B1**

(12) **EUROPÄISCHE PATENTSCHRIFT**

(45) Veröffentlichungstag und Bekanntmachung des
Hinweises auf die Patenterteilung:
**04.06.2003 Patentblatt 2003/23**

(51) Int Cl.⁷: **G11C 11/30**, G11C 11/24

(21) Anmeldenummer: **97104920.0**

(22) Anmeldetag: **22.03.1997**

(54) **Digatalspeicherelement**

Digital memory element

Elément de mémoire digital

(84) Benannte Vertragsstaaten:
**AT BE CH DE DK ES FI FR GB GR IE IT LI LU MC
NL PT SE**

(30) Priorität: **09.08.1996 DE 19632136**

(43) Veröffentlichungstag der Anmeldung:
**11.02.1998 Patentblatt 1998/07**

(73) Patentinhaber: **Deutsche Telekom AG
53113 Bonn (DE)**

(72) Erfinder:
• **Koops, Hans W.P., Dr.
64372 Ober-Ramstadt (DE)**
• **Hanke, Gerhard, Dipl.-Ing.
64372 Ober-Ramstadt (DE)**

(56) Entgegenhaltungen:
**US-A- 2 840 799**　　　US-A- 3 470 541
**US-A- 5 471 087**

Anmerkung: Innerhalb von neun Monaten nach der Bekanntmachung des Hinweises auf die Erteilung des europäischen Patents kann jedermann beim Europäischen Patentamt gegen das erteilte europäische Patent Einspruch einlegen. Der Einspruch ist schriftlich einzureichen und zu begründen. Er gilt erst als eingelegt, wenn die Einspruchsgebühr entrichtet worden ist. (Art. 99(1) Europäisches Patentübereinkommen).

**Beschreibung**

Die Erfindung bezieht sich auf ein Digitalspeicherelement der im Oberbegriff des Patentanspruchs 1 näher definierten Art. Speicherschaltungen solcher Art sind mit diskreten Bauelementen vorausgesetzt. Vergleichbare Digitalspeicherelemente sind noch nicht bekannt.

Von Digitalspeicherelementen wird neben geringer Größe vor allem eine hohe Geschwindigkeit der Ein- und Auslesevorgänge verlangt. Halbleiterspeicher erreichen zwar hohe Speicherdichte/ aber nur Bruchteile von GHz. Digitalspeicherelemente mit einer Speicherkapazität und mehreren Röhren, von denen wenigstens eine mit Elektronenstrahlablenkung gesteuert ist, sind bisher nicht bekannt.

Auf miniaturisierten Feldemissions-Röhren basierende Digitalspeicherelemente, die bei Frequenzen im oberen GHz-Bereich arbeiten sind nicht bekannt. Die herkömmlichen Vakuum-Mikroelektronischen Röhren leiden an einer zu großen Gitter-Anoden und Gitter-Kathoden-Kapazität, die ihre Funktionsweise auf wenige GHz begrenzt. Zuverlässige Mikroröhren aus Metall oder Siliziumkathoden sind bisher nicht vorgestellt worden. Die durch den Herstellungsprozeß bedingte Individualität der einzelnen Emitter und die Schwierigkeit pro Emitter einen den Strom stabilisierenden Widerstand oder Regler einzubauen haben bisher die weitere Verwendung derartiger Elemente für komplexe Schaltungen verhindert [I. Brodie, J. J. Muray "The physics of micro and nano-fabrication" Plenum Press, NY 1992]. Bisher können halbwegs zuverlässige Ergebnisse nur durch die Verwendung von ganzen Kathoden-Arrays erzielt werden und sind auch Grundlage zur Herstellung flacher Bildschirme mit Feldemittern, die mittels additiver Lithographie erzeugt sind. [DE-OS 44 16 597.8].

Als additive Lithographie wird eine Technologie bezeichnet, bei der auf einer Oberfläche, ohne die das Substrat maskierenden Lithographieschritte, Material strukturiert aus der Gasphase unter Wirkung des Elektronenstrahls direkt abgeschieden wird und ohne weitere Schritte weiter verwendet werden kann.

Der Begriff additive Lithographie wurde weiterhin in verschiedenen Veröffentlichungen zu dieser Technologie publiziert:

J. Kretz, M. Rudolph, M. Weber, H.W.P. Koops, "Three Dimensional Structurization by Additive Lithography, Analysis of Deposits using TEM and EDX, and Application for Field Emitter Tips" in Microelectronic Engineering 23 (1994) S. 477-481, sowie:

H.W.P. Koops, J. Kretz, M. Rudolph, M. Weber, G. Dahm, K.L. Lee, Characteriization and application of materials grown by electronic beam induced deposition", Jpn. J. Appl Phys Vol. 33(1994) 7099-7107 Part. 1 No. 12B, December 1994.

Ein Digitalspeicherelement mit Einschreib, Lese und Löscheinrichtung ist auch aus diesen Quellen nicht bekannt noch herleitbar.

Die Erfindung hat sich zur Aufgabe gestellt, ein Digitalspeicherelement zu schaffen, das sich mit Frequenzen im oberen GHz-Bereich beschreiben und lesen läßt und das in seinen geometrischen Abmessungen so klein ist, daß große Speicherdichte erzielbar ist.

Die Erfindung löst diese Aufgabe mit den im Kennzeichen des Patentanspruchs 1 aufgeführten Merkmalen.

Vorteilhafte Weiterbildungsmöglichkeiten sind in den Kennzeichen der Unteransprüche 2 bis 4 beschrieben.

Die Erfindung wird nachfolgend anhand von Ausführungsbeispielen näher erklärt. In der zugehörigen Zeichnung ist als

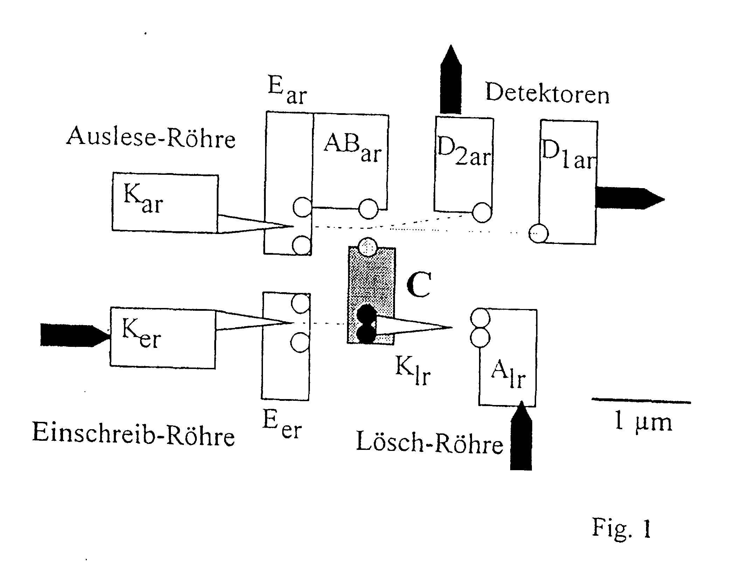

Fig. 1 die Struktur eines Digitalspeicherelements dargestellt.

Die Fig. 1 zeigt eine schnelles Digitalspeicherelement aus drei miniaturisierten Röhren mit THz-Schalteigenschaften. Die Einschreib-Röhre wird benutzt, um die Speicherkapazität C zu laden Die Lösch-Röhre wird benutzt, um die Speicherkapazität C zu entladen Die Auslese-Röhre wird benutzt, um den Zustand der Speicherkapazität C auszulesen.

Die kleine Speicherkapazität C steht mit Elementen von zwei miniaturisierten Elektronenröhren, und zwar mit der Anode einer Einschreib-Röhre und mit der Kathode einer Lösch- Röhre $K_{lr}$ und mittelbar ablenkend mit der Ablenkelektrode einer Auslese-Röhre $AB_{ar}$ mit Elektronenstrahlablenkung in Verbindung. Der Elektronenstrahl der Auslese-Röhre trifft, abhängig vom unverändert bleibenden Ladezustand der Speicherkapazität C, auf einen von zwei in den Strahlrichtungen angeordneten und mit den Zustandsausgängen verbundenen Detektoren (ungeladen auf $D_{1ar}$ bzw. bei negativer Ladespannung auf $D_{2ar}$) auf. Die Anode $A_{lr}$ ist neben der Speicherkapazität C angeordnet. Die Feldemissionskathode $K_{lr}$ dieser Lösch-Röhre ist Teil der Speicher-Kapazität. Der Ladezustand der Kapazität wird durch die Ausleseröhre angezeigt. Diese emittiert einen Elektronenstrahl und enthält als zweites Element ein Ablenkelement AB. Bei ungeladener Speicherkapazität C geht der Strahl der Röhre geradlinig durch das Ablenkelement AB hindurch und landet auf dem Detektor D1. Ist die Speicherkapazität C geladen, so bewirkt die ebenfalls zur Kapazität gehörige Ablenkelementseite durch ihre Auflading und das so entstandene elektrische Feld die Ablenkung des Strahles, so daß dieser auf den Detektor D2 trifft.

Die Erfindung basiert auf der Anwendungen der Elektronenstrahl- induzierten Deposition. Diese additive Lithographie mit Elektronen ermöglicht es miniaturisierte Röhren mit $0.5\,\mu m$ Länge und $1\,\mu m$ Breite auf einer metallischen Leiterbahnstruktur mit Hilfe eines rechnergesteuerten Elektronenstrahles aufzubauen. Durch die Herstellungsmethode können sehr feine leitfähige Spitzen für die Elektronenemission durch Tunneleffekt direkt an der erforderlichen Stelle der Schaltung aufgebaut werden. Aus deponierten senkrecht stehenden oder im Raum beim Aufbau geführten Drähten können die benötigten Detektoren und Extraktorstrukturen aufgebaut werden.

Alle Strukturen sind 0.1-0.2 μm dick und ca. 2 μm hoch. Dadurch ist die Gesamtstruktur sehr klein und benötigt keinen hohen Strom und keine hohe Leistung. Die Drähte mit 0.1 μm Durchmesser und bis zu 10 μm Länge können eine bis zu 2 MA/cm$^2$ große Stromdichten tragen. Der Wert ist 8 mal höher als z.B. bei Aluminium (250000A/cm$^2$). Feldemission ist aus den Drahtspitzen mit ca. 15-fach geringerem Innenwiderstand möglich als bei herkömmlichen Feldemittern der Vahuumikroelectronik. Feldemitter - Elektronenquellen können mit dieser Technik mit eingebautem StromStäbilisierwiderstand aufgebaut werden. Damit arbeitet jede Spitze kontrolliert und die Anforderung nach Redundanz an die Spitzen in der Röhre oder in den parallel angeordneten Emittern wird verringert.

Die Drähte enden in einer sehr feinen Spitze mit Radien > 5 nm, aber mit nanometergroßen Kristallen, die aus der Spitze nerausragen und dadurch eine Feldverstärkung bewirken. Das außert sich in einer stark verringerten Extraktionsspannung für den Feld-Elektronen-Strom. Der Widerstand der deponierten Materialien ist über die Depositions-Bedingungen im Bereich von 5 Grössenordnungen einstellbar. Damit kann mit der Feldemission ein Röhren-Innenwiderstand unter MW erreicht werden. Die Speicherfunktionen können mit einem Signal zu Rausch-Abstand von 100 ausgeführt werden, wenn 10 000 Elektronen zur Ladung der Kapazität eingesetzt werden. Zur Stromstabilisierung der Emission kann mit dem Verfahren ein Stabilisierwiderstand pro Emitterspitze eingefügt werden, so daß stets die gleiche Anzahl von Elektronen verwendet wird.

Das Bauelement benötigt kein Halbleitermaterial als Grundlage. Glas oder Quarz können eingesetzt werde. Die Leiterbahnen werden im Lift-off-Prozess durch Lithographie und Aufdampfen hergestellt . Die Technik ist zu allen anderen elektronischen Aufbautechniken kompatibel.

Mit der rechnergesteuerten Deposition werden 3-dimensionale Strukturen hergestellt, die als Elektroden für Mikro-Röhren und Röhrensysteme dienen, die einzelne Strahlen erzeugen, oder die vielmals nebeneinander hergestellt werden können.

Damit ist eine Technik gefunden, mit der vielfache Elektronenstrahlen auf lithographischen Schaltungen und Trägerplatinen hergestellt werden können, die dann wiederum Trägerplatinen hergestellt werden können, die dann wiederum als Produktionsmittel für Depositions-Strukturen einsetzbar sind. Aus derartigen Mikroröhren, ist der beschriebene schnelle löschbare Digitalspeicher mit 100 GHz Schaltzeiten in paralleler Herstellungstechnik zu produzieren.

Durch die Feinheit der Definition der Materialerzeugung mit Rechnersteuerung können neuartige Röhren Bauelemente , Differenzverstärker und andere Schaltungen ohne die Verwendung von Halbleitermaterialien direkt aufgeschrieben werden. Diese Schaltungen können auf Grund der Kleinheit und der Nanometerpräzision bei höheren Frequenzen als sie mit herkömmlichen Röhren erreichbar, betrieben werden. Die Herstellungstechnik für elektronische Schaltungen ist stark vereinfacht, die Packungsdichte ist stark erhöht.

Die Herstellung der Digitalspeicherelemente kann mit additiver Lithographie aus Mikroröhren erfolgen, (entsprechend der erwähnten früheren Patentanmeldung DE-OS 44 16 597.8), ohne die Verwendung von Halbleiter-Materialien mit Nanometer-Präzision durch Rechnersteuerung, mit für hohe Lebensdauer kontrollierten Feldstärken im Element die nur im Emitterbereich über 10$^6$ V/cm ansteigen. Dadurch wird das Wachstum von Kohlenstoff-Brücken aus Polymeren als Kurzschlußleiter verhindert und unterdrückt. Die Erhöhung der "transconductance", Erniedrigung des Innenwiderstandes, gelingt, falls erforderlich, durch die Verwendung mehrerer deponierter Kathoden mit nanokristallinem Aufbau, sowie durch Erhöhung der Packungsdichte der Röhren unter Verwendung von 0,5 μm Technologie für Leiterbahnen und Abstände. Fig. 1 zeigt den Prinzipaufbau des Digitalspeicherelementes mit je einer Einschreib-, Lösch- und Ausleseröhre.

Die Funktionsweise des Digitalspeicherelementes ist wie folgt erklärbar:

1) Aufladen der Speicherkapazität C mit Einschreib-Röhre durch Spannung an $K_{er}$ bis zur erforderlichen Ablenk-Spannung am Ablenkelement $AB_{ar}$ der Auslese-Röhre. Spannungspuls mit Strombegrenzer-Widerstand kann die Ladungsmenge definieren.

2) Auslesen der Kapazität mit der Ausleseröhre. Bei ungeladener Kapazität fällt der Auslesestrahl auf den Detektor $D_{1ar}$. Bei anliegender negativer Ladespannung an der Kapazität wird der Auslesestrahl abgelenkt und fällt auf den Detektor $D_{2ar}$. So kann der Ladezustand ausgelesen werden ohne den Speicherinhalt zu verändern.

3) Löschen des Speicherinhaltes der Kapazität C geschieht durch Anlegen einer Lösch-Extraktorspannung + $U_{extr}$ an der Anode der Löschröhre $A_{lr}$. Bei angelegter Spannung erfolgt Feldemission an der Löschröhre. Der Entladestrom kann auf 150 μA eingestellt werden, so daß die Entladung in 0.1 ps erfolgen kann um steilere Pulsprofile zu erhalten.

Schaltspannungen - 20 V bis +20 V für Experimente (im Einsatzfall real +- 10 V).

Layout CD = 0.5 µm (kleinste Linienbreite und Linienabstand (Au-lift-off).

Deponatstrukturen aus $Me_2Au$(tfac), bei 300 pA Schreibstrom, 25 keV Elektronen.

3 Kathoden-Spitzen je 2 Min = 6 Min, 12 Extraktor oder Anodendrähte 1µm je 1 Min = 12 Minuten. Rechnergesteuerte Plazierung der Deponate in 4µm x 2 µm großem Gesichtsfeld

Eine Abschätzung zur Grenzfrequenz der Schreib-, Lösch- und Lesevorgänge ergibt folgende Werte:

Annahme:

Die Feldemitter-Röhre arbeitet bei 150 µA, $U_{extr} < 10$ V, Transconductance $R_i > 15$ µS

Schaltmöglichkeiten der Feldemissionsröhre:

    1) Spitze auf - $U_{ext}$; Extraktor auf 0 V, (Einschreibröhre)
    2) Extraktor auf +$U_{extr}$ , Spitze auf 0 V; (Löschröhre)
    3) Ablenkung des Strahles mit Ablenkplatten Up < 10 V (Ausleseröhre)

Speicherkapazität

$$C=e_0 \; e_r \cdot F/d=8{,}86 \cdot 10^{-12} \; 1 \cdot (0.2 \cdot 10^{-6})^2/10^{-6} \; As/V=3{,}5 \cdot 10^{-18} \; F$$

Stabdurchmesser 0.2 µm, Länge 1 µm, Abstand, 1µm, Dielektrikum Luft $e_r$ = 1

Um diese Kapazität auf 5 Volt Ablenkspannung zu laden ist eine Ladung von

$$Q=C \cdot U =1{,}6 \cdot 10^{-17} \; As=100e = 100 \; \text{Elektronen erforderlich.}$$

Diese Ladung kann in 1 psec mit einem Strom von 16 µA aufgebracht werden (entspricht einer Frequenz 1 THz).

Der statistische Fehler ist dann 10 % oder S/N = 10 (Signal-Rausch-Verhältnis)

Schalten mit 0.1 ps kann bei 160 µA Entladestrom erfolgen (Spannungspuls an der Extraktor-Röhre)

**Patentansprüche**

**1.** Digitalspeicherelement mit Eingangsanschlüssen zum Einschreiben und zum Löschen und Ausgängen zum Zustandsauslesen, das aus einer kleinen Speicherkapazität (C) und mehreren lithographisch miniaturisierten Elektronenröhren besteht, von denen wenigstens eine mit Elektronenstrahlablenkung gesteuert ist, **dadurch gekennzeichnet, daß** die Speicherkapazität (C) mit Elementen von zwei miniaturisierten Elektronenröhren, und zwar mit der Anode einer Einschreib- Röhre ($K_{er}$) und mit der Kathode einer Lösch- Röhre ($K_{lr}$) und mittelbar ablenkend mit der Ablenkelektrode einer Auslese- Röhre ($AB_{ar}$) mit Elektronenstrahlablenkung in Verbindung steht, und daß der Elektronenstrahl der Auslese- Röhre, abhängig vom unverändert bleibenden Ladezustand der Speicherkapazität (C), auf einen von zwei in den Strahlrichtungen angeordneten und mit den Zustandsausgängen verbundenen Detektoren ($D_{1ar}$, $D_{2ar}$) auftrifft.

**2.** Digitalspeicherelement nach Anspruch 1, **dadurch gekennzeichnet, daß** die Einschreib- und Lösch- Röhre Dioden sind und daß der Kathode der Einschreib- Röhre ($K_{er}$) ein Strombegrenzer- Widerstand zugeordnet ist, der die Ladungsmenge an der Speicherkapazität C bei einem Spannungspuls entsprechend der erforderlichen Ablenk-Spannung am Ablenkelement ($AB_{ar}$) der Auslese-Röhre definiert.

**3.** Digitalspeicherelement nach Anspruch 1, **dadurch gekennzeichnet, daß** die Auslese- Röhre aus einer Kathode, einem geteilten Extraktor ($E_{ar}$) und zwei gegeneinander isolierten Anoden besteht, die mit Ausgangsanschlüssen bzw. weiteren Speicherelementen einer Speichermatrix verbunden sind.

4. Digitalspeicherelement nach Anspruch 1, **dadurch gekennzeichnet, daß** gegenüber einer mit der Speicherkapazität C verbundenen Feldeffektkathode für das Löschen des Speicherinhaltes die Anode der Lösch- Röhre ($A_{lr}$) angeordnet ist, mit der durch Anlegen einer Lösch-Extraktorspannung $+ U_{extr}$ die Entladung mittels Feldemission erfolgt.

## Claims

1. Digital memory cell element with input terminals for writing and erasing and with outputs for reading the state, said digital memory cell element consisting of a small memory cell capacitor (C) and of a plurality of lithographically miniaturized electron tubes, at least one of which is controlled by electron beam deflection, **characterized in that** the memory cell capacitor (C) is in communication with elements of two miniaturized electron tubes, more specifically with the anode of a writing tube ($K_{er}$) and with the cathode of an erasing tube ($K_{lr}$) and indirectly deflectingly with the deflecting electrode of a reading tube ($AB_{ar}$) with electron beam deflection, and **in that** the electron beam of the reading tube impinges, depending on the unchanged state of charge of the memory cell capacitor (C), on one of two detectors ($D_{1ar}$, $D_{2ar}$) disposed in the beam directions and connected to the state outputs.

2. Digital memory cell element according to claim 1, **characterized in that** the writing and erasing tubes are diodes and **in that** the cathode of the writing tube ($K_{er}$) is associated with a current limiting resistor, said current limiting resistor defining the charge at the memory cell capacitor C in the case of a voltage pulse according to the required deflecting voltage at the deflecting element ($AB_{ar}$) of the reading tube.

3. Digital memory cell element according to claim 1, **characterized in that** the reading tube consists of a cathode, a split extractor ($E_{ar}$) and two mutually insulated anodes, said anodes being connected to output terminals or further memory cell elements of a memory cell matrix.

4. Digital memory cell element according to claim 1, **characterized in that** disposed opposite a field effect cathode connected to the memory cell capacitor C for erasing the memory cell contents is the anode of the erasing tube ($A_{lr}$), with which discharging is accomplished by means of field emission by applying an erasing extractor voltage $+ U_{extr}$

## Revendications

1. Elément de mémoire numérique avec accès d'entrée pour écriture et effacement et sorties pour lecture d'état, constitué d'une capacité de mémoire de taille réduite (C) et de plusieurs tubes électroniques lithographiquement miniaturisés, l'un au moins d'entre eux étant commandé par déviation de faisceau d'électrons, **caractérisé en ce que** la capacité de mémoire (C) est reliée à des éléments de deux tubes électroniques miniaturisés, à savoir à l'anode d'un tube d'écriture ($K_{er}$) et à la cathode d'un tube d'effacement ($K_{lr}$) et, par déviation indirecte, à l'électrode de déviation d'un tube de lecture ($AB_{ar}$) avec déviation de faisceau d'électrons, et **en ce que** le faisceau d'électrons du tube de lecture heurte, sous réserve d'un état de charge constant de la capacité de mémoire (C), l'un de deux détecteurs ($D_{1ar}$, $D_{2ar}$) disposés dans le sens du rayonnement et reliés aux sorties d'état.

2. Elément de mémoire numérique selon la revendication 1, **caractérisé en ce que** les tubes d'écriture et d'effacement sont des diodes et la cathode du tube d'écriture ($K_{er}$) est soumise à une résistance limiteuse de courant, qui définit la charge au niveau de la capacité de mémoire C pour une impulsion de tension correspondant à la tension de déviation nécessaire sur l'élément de déviation ($AB_{ar}$) du tube de lecture.

3. Elément de mémoire numérique selon la revendication 1, **caractérisé en ce que** le tube de lecture consiste en une cathode, un extracteur partagé ($E_{ar}$) et deux anodes isolées l'une par rapport à l'autre, qui sont reliées à des sorties ou à d'autres éléments de mémoire d'une grille de mémoire.

4. Elément de mémoire numérique selon la revendication 1, **caractérisé en ce que**, en face d'une cathode à effet de champ reliée à la capacité de mémoire C, est placée, pour l'effacement des contenus mémorisés, l'anode du tube d'effacement ($A_{lr}$), avec laquelle la décharge a lieu par émission de champ, par application d'une tension d'extraction d'effacement $+ U_{extr}$ .

Fig. 1